**Europäisches Patentamt**

**European Patent Office**

**Office européen des brevets**

(19)

(11) Veröffentlichungsnummer: **0 137 306**
**A2**

(12) # EUROPÄISCHE PATENTANMELDUNG

(21) Anmeldenummer: **84110583.6**

(22) Anmeldetag: **06.09.84**

(51) Int. Cl.⁴: **C 01 B 33/02**
**C 30 B 15/00**

(30) Priorität: **08.09.83 DE 3332447**

(43) Veröffentlichungstag der Anmeldung:
**17.04.85 Patentblatt 85/16**

(84) Benannte Vertragsstaaten:
**DE FR IT**

(71) Anmelder: **Wacker-Chemitronic Gesellschaft für Elektronik-Grundstoffe mbH**
**Johannes-Hess-Strasse 24**
**D-8263 Burghausen(DE)**

(72) Erfinder: **Griesshammer, Rudolf, Dr. Dipl.-Chem.**
**Megerleweg 6**
**D-8262 Altötting(DE)**

(72) Erfinder: **Peterat, Michael, Dr. Dipl.-Mineraloge**
**Kettelerstrasse 1**
**D-8261 Emmerting(DE)**

(54) **Verfahren zur Befreiung von Siliciumbruchstücken von Verunreinigungen.**

(57) Es wird ein Verfahren angegeben, gemäß welchem Siliciumbruchstücke, die durch Zerkleinern von durch Gasphasenabscheidung hergestellten, polykristallinen Siliciumformkörpern gewonnen wurden, von kohlenstoff- und eisenhaltigen Verunreinigungen befreit werden können. Das nach Nitrat-, Glüh- und Säure- bzw. Magnetbehandlung erhaltene Produkt eignet sich für den Einsatz im Tiegelziehprozeß nach Czochralski.

EP 0 137 306 A2

Croydon Printing Company Ltd.

WACKER-CHEMITRONIC — 1 — München, den 23.8.1983
Gesellschaft für Elektronik-     PAT/Dr.K/we
      Grundstoffe mbH

0137306

Wa-Ch 8211
==========

## Verfahren zur Befreiung von Siliciumbruchstücken von Verunreinigungen

Die Erfindung betrifft ein Verfahren zur Befreiung von Siliciumbruchstücken, welche beim Zerkleinern von polykristallinen Siliciumformkörpern anfallen, von Verunreinigungen.

Elektronische Bauelemente werden in den meisten Fällen aus Siliciumscheiben gefertigt, welche aus durch Tiegelziehen nach Czochralski hergestellten Siliciumstäben gesägt werden. Bei dem Tiegelziehprozeß wird polykristallines Silicium in groben Stücken in im allgemeinen aus Quarz bestehenden Tiegeln aufgeschmolzen und aus der Schmelze nach Animpfen der gewünschte Kristall gezogen. Das grobstückige Silicium wird meist mittels Backenbrechern durch Zerkleinern von polykristallinen Siliciumformkörpern, wie z.B. Stäben, hergestellt, welche durch Zersetzung von Halogensilanen, z.B. Trichlorsilan, auf erhitzten Trägerkörpern aus beispielsweise Silicium, Graphit oder Graphitfolie (vgl. DE-OS 26 18 273 bzw. US-PS 4 160 797) gewonnen werden.

Allerdings eignen sich die bei dem Zerkleinerungsschritt erhaltenen Siliciumbruchstücke erst ab einer bestimmten Korngröße für den Einsatz beim Tiegelziehen; die Grenze liegt in der Regel bei der Siebfraktion über 8 mm Siebweite. Partikel mit geringerer Korngröße weisen nämlich meist einen zu hohen Anteil an Verunreinigungen, z.B. Abrieb von den Zerkleinerungsmaschinen, Rückstände des Trägerkörper- oder Elektrodenmaterials oder dergleichen auf. Aus diesem Grunde wird die Siebfraktion unter 8 mm als sogenannter "Abfallbruch" verworfen, was einen Materialverlust von etwa

10 %, schlechten Füllungsgrad der Tiegel und damit eine unbefriedigende Wirtschaftlichkeit des Verfahrens bedeutet.

Die Aufgabe der Erfindung lag also darin, ein Verfahren anzugeben, welches es gestattet, Siliciumbruchstücke, insbesondere den sogenannten Abfallbruch, so von Verunreinigungen zu befreien, daß sie beim Tiegelziehen nach Czochralski eingesetzt werden können.

Gelöst wird diese Aufgabe durch ein Verfahren, welches gekennzeichnet ist durch folgende Schritte:

a) Behandeln der Bruchstücke mit wäßriger Nitratlösung

b) Glühen der behandelten Bruchstücke

c) Behandeln der geglühten Bruchstücke mit Flußsäure

d) ggf. Abtrennen eisenhaltiger Verunreinigungen durch Säure- oder Magneteinwirkung, einzeln oder in Kombination.

Dieses Verfahren läßt sich allgemein für Siliciumbruchstücke einsetzen, welche beim Zerkleinern von durch Gasphasenabscheidung gewonnenen Siliciumformkörpern, z.B. Stäben oder Rohren, mittels Zerkleinerungsmaschinen, wie z.B. Backenbrechern, erhalten werden. Typische dabei auftretende Verunreinigungen sind einerseits der eisenhaltige Abrieb von den zumeist stählernen Zerkleinerungsmaschinen, andererseits elementarer Kohlenstoff, z.B. als Rückstand von den Elektroden und/oder den Trägerkörpern, auf denen das zu zerkleinernde, polykristalline Siliciummaterial abgeschieden wurde.

Grundsätzlich ist das Verfahren von der Korngröße der erhaltenen Bruchstücke nicht abhängig und kann bei den verschiedensten Körnungsstufen angewendet werden. So läßt sich beispielsweise auch die großvolumige Bruchstückfraktion von auf Graphitfolie abgeschiedenem Silicium von anhaftendem Trägermaterial befreien. Bei auf Siliciumträgerkörpern abgeschiedenem Material sind die Verunreinigungen, z.B. der Metallabrieb, erfahrungsgemäß erheblich kleiner als der Großteil der Siliciumbruchstücke, so daß nach einer Klassierung bezüglich der Korngröße im Regelfall lediglich die Siebfraktionen einer Reinigung bedürfen, die bei einer Siebweite von etwa 4 mm, bei starker Verunreinigung bis ca. 10 mm, erhalten werden. Eine Klassierung des zu reinigenden Materials kann aber auch unterbleiben, wenn, wie etwa im Fall von auf Graphitfolie abgeschiedenem Silicium, von nahezu jedem Bruchstück Reste des Trägermaterials entfernt werden müssen.

Der erste Schritt bei der Befreiung des Siliciumbruchs von kohlenstoffhaltigen Verunreinigungen ist die Behandlung mit einer wäßrigen Nitratlösung. Schon aus Kostengründen wird man dabei vor allem auf Kalium- oder insbesondere Natriumnitratlösung zurückgreifen, wenngleich auch die Verwendung anderer Nitrate, wie z.B. Lithium-, Calcium-, Strontium-Barium- oder Magnesiumnitrat nicht ausgeschlossen werden soll.

Zweckmäßig wird die gewählte Nitratlösung in einer Konzentration von etwa 30 bis 45 Gew.-%, vorzugsweise annähernd gesättigt, eingesetzt und beispielsweise über die Siliciumbruchstücke gesprüht oder gegossen. Besonders bewährt hat es sich jedoch, die Bruchstücke in eine in einem Bad vorgelegte Lösung einzutauchen oder einzulegen, um eine zuverlässige allseitige Benetzung zu erreichen. Als vorteilhaft hat sich bei diesem Verfahren auch erwiesen, das Bad mittels Heizvorrichtungen auf erhöhte Temperatur einzustellen. Günstig
wird dabei eine möglichst hohe Temperatur in der Nähe des
Siedepunktes der jeweiligen Lösung, also im Bereich von ca.
90 - 100 °C, eingehalten. In der Regel reicht für die Einwirkung der Nitratlösung bereits eine Zeitdauer von 5 bis 30
Minuten aus.

Im Anschluß an den ersten Verfahrensschritt werden die mit
Nitratlösung benetzten Siliciumbruchstücke geglüht, und zwar
vorteilhaft bei einer Temperatur von 900 bis 1300 °C, vorzugsweise 1000 bis 1150 °C, und unter Luftzutritt. Für diesen Zweck eignen sich beispielsweise widerstands- oder gasbeheizte Öfen, wie die aus der keramischen Industrie bekannten Brennöfen. Die Zeitdauer der Glühbehandlung verkürzt sich
mit steigender Temperatur und beträgt bei 1000 - 1150 °C in
der Regel 1/4 - 3 Stunden. Während dieser Zeit werden die
kohlenstoffhaltigen Verunreinigungen oxidiert und als Kohlenmono- bzw. -dioxid aus dem Gemisch entfernt. Als Rückstand verbleiben die kohlenstofffreien Siliciumbruchstücke,
die mit einer lackartigen, farblosen Silikatschicht überzogen sind, sowie ggf. die zumindest teilweise oxidierten
eisenhaltigen Verunreinigungen.

Dieser Rückstand wird nach Abkühlung einer Behandlung mit
Flußsäure unterworfen, um die Silikatschicht von den Siliciumbruchstücken abzuätzen. Zweckmäßig wird dazu etwa 20 bis
40 Gew.-%-ige, vorteilhaft heiße Flußsäure eingesetzt, beispielsweise in Form eines Bades, in welches die Bruchstücke
eingelegt werden können. Für die Einwirkung der Flußsäure
werden in der Regel etwa 5 bis 10 Minuten benötigt. Anschließend wird der Rückstand säurefrei gewaschen und getrocknet; er besteht aus nunmehr kohlenstoff- und silikatfreiem Silicium sowie den ggf. verbliebenen, eisenhaltigen
Verunreinigungen.

Deren Abtrennung kann auf verschiedene Art geschehen. Eine Möglichkeit besteht darin, durch Magnetscheidung, beispielsweise mittels Überband-Magnetscheider, die eisenhaltigen, magnetischen Teilchen aus dem Gemenge zu entfernen. Eine zweite Möglichkeit ist die chemische Abtrennung durch Auflösen der eisenhaltigen Verunreinigungen in geeigneten, elementares Silicium nicht angreifenden Säuren, z.B. Salzsäure, Salpetersäure oder Königswasser. Dieser chemische Reinigungsschritt erfordert in der Regel etwa 1 bis 5 Stunden. Beide Verfahren lassen sich auch kombinieren, wobei die Säurebehandlung sowohl vor als auch nach der Magnetscheidung durchgeführt werden kann. Abschließend wird das Silicium säurefrei gewaschen und getrocknet und kann z.B. im Tiegelziehprozeß nach Czochralski eingesetzt werden.

Die Abtrennung der eisenhaltigen Verunreinigungen kann grundsätzlich auch nach dem Glühschritt und vor der Flußsäurebehandlung oder, günstiger, als erster Verfahrensschritt vor Abtrennung der kohlenstoffhaltigen Verunreinigungen erfolgen. Sie kann sogar unterbleiben, wenn eine Siebfraktion ausgewählt wird, die aufgrund ihrer Körnungsstufe keine eisenhaltigen Verunreinigungen enthält.

Das erfindungsgemäße Verfahren ermöglicht es somit, polykristallines Silicium von Verunreinigungen zu befreien, die teils aus dem Abscheidevorgang, teils aus dem anschließenden Zerkleinerungsschritt stammen. Das solchermaßen gereinigte Silicium kann ohne Einschränkung im Tiegelziehprozeß nach Czochralski eingesetzt werden. Dadurch wird eine bessere Ausnutzung des wertvollen, abgeschiedenen Siliciumgrundmaterials sowie über die Erhöhung des Füllungsgrades der Schmelztiegel auch eine gesteigerte Wirtschaftlichkeit des Tiegelziehprozesses erreicht.

Die nachstehenden Ausführungsbeispiele sind zur Erläuterung, nicht aber zur Beschränkung des erfindungsgemäßen Verfahrens gedacht.

## Beispiel 1

Auf Trägerkörpern aus hochreinem Silicium durch Zersetzung von Trichlorsilan abgeschiedenes polykristallines Silicium in Stabform wurde mittels Backenbrecher zerkleinert. Die Bruchstücke wurden über eine Siebanlage klassiert und die Siebfraktion bis zu einer Siebweite von 4 mm abgetrennt. Diese Fraktion (Gewicht ca. 20 kg), der sogenannte "Abfallbruch", enthielt etwa $5 \cdot 10^{17}$ Atome/cm³ Silicium an kohlenstoffhaltigen Verunreinigungen und, durch optisches Auslesen nachgewiesen, etwa 1000 ppm. sichtbare eisenhaltige Verunreinigungen, z.B. Stahlpartikel.

Zunächst wurde zur Entfernung der eisenhaltigen Verunreinigungen der Siliciumbruch etwa 2 Stunden in bei ca. 50 °C gehaltener, konzentrierter Salzsäure ausgelaugt. Das Produkt wurde anschließend säurefrei gewaschen, etwa 30 Minuten in ein Bad von ca. 40 Gew.-%-iger, wäßriger Natriumnitratlösung (Temperatur ca. 90 °C) eingelegt, und danach etwa 1 Stunde in einem Glühofen bei ca. 1100 °C geglüht. Nach Abkühlung wurde die lackartige, das Silicium bedeckende Silikatschicht in konzentrierter Flußsäure bei ca. 70 °C ca. 10 Minuten lang abgeätzt. Anschließend wurde das Produkt noch etwa 20 Minuten unter fließendem, entsalztem Wasser säure- und salzfrei gewaschen und schließlich mit Heißluft getrocknet.

Die so gereinigten Siliciumbruchstücke besaßen einen Kohlenstoffgehalt von weniger als $0,5 \cdot 10^{17}$ Atome/cm³ Silicium. Optisch konnten keine eisenhaltigen Verunreinigungen mehr festgestellt werden.

Das erhaltene Silicium konnte beim Tiegelziehen nach Czochralski eingesetzt werden. Die daraus gezogenen Vergleichsstäbe besaßen einen gegenüber ungereinigtem Material etwa um den Faktor 50 bis 150 verbesserten spezifischen Widerstand.

Beispiel 2

Auf Trägerkörpern aus Graphitfolie durch Zersetzung von Trichlorsilan abgeschiedenes polykristallines Silicium in Stabform wurde mittels Backenbrecher aus Stahl zerkleinert. Über eine Siebanlage wurde die Siebfraktion unter 10 mm Siebweite, in der sich die Verunreinigungen durch Stahlabrieb befanden, abgetrennt und verworfen.

Die verbleibende Fraktion (Gewicht etwa 20 kg), die als Verunreinigung nur noch die anhaftenden Reste der Graphitfolie enthielt, wurde zunächst etwa 30 Minuten in ein Bad von auf 90 °C gehaltener, ca. 40 Gew.-%-iger Natriumnitratlösung eingelegt. Danach wurde das Material entnommen und etwa 30 Minuten in einem Glühofen bei ca. 1100 °C geglüht. Anschließend wurden die Bruchstücke etwa 10 Minuten mit auf 70 °C gehaltener, konzentrierter Flußsäure abgeätzt, sodann mit entsalztem Wasser bei Raumtemperatur säure- und salzfrei gewaschen und mit Heißluft getrocknet.

Der Kohlenstoffgehalt lag nach dieser Behandlung unter $0,5 \cdot 10^{17}$ Atome/cm³ Silicium. Das erhaltene Silicium konnte ohne Einschränkung beim Tiegelziehprozeß nach Czochralski eingesetzt werden.

## P a t e n t a n s p r ü c h e

1. Verfahren zur Befreiung von Siliciumbruchstücken, welche beim Zerkleinern von polykristallinen Siliciumformkörpern anfallen, von Verunreinigungen, g e k e n n z e i c h n - n e t   d u r c h   folgende Schritte:

   a) Behandeln der Bruchstücke mit wäßriger Nitratlösung

   b) Glühen der behandelten Bruchstücke

   c) Behandeln der geglühten Bruchstücke mit Flußsäure

   d) ggf. Abtrennen eisenhaltiger Verunreinigungen durch Säure- oder Magneteinwirkung einzeln oder in Kombination.

2. Verfahren nach Anspruch 1, d a d u r c h   g e k e n n - z e i c h n e t ,   daß als Nitratlösung heiße Natrium- oder Kaliumnitratlösung eingesetzt wird.

3. Verfahren nach Anspruch 1 und 2, d a d u r c h   g e - k e n n z e i c h n e t ,   daß das Glühen bei 1000 bis 1100 °C durchgeführt wird.

4. Verfahren nach den Ansprüchen 1 bis 3, d a d u r c h   g e k e n n z e i c h n e t ,   daß die eisenhaltigen Verunreinigungen durch Salzsäure oder Salpetersäure oder eine Mischung beider Säuren abgetrennt werden.

5. Verfahren nach Anspruch 4, d a d u r c h   g e k e n n - z e i c h n e t ,   daß die Abtrennung der eisenhaltigen Verunreinigungen als erster Verfahrensschritt erfolgt.